# EUROPEAN PATENT APPLICATION

(11) **EP 3 687 179 A1**
(43) Date of publication of application: **29.07.2020**
(21) Application number: 19208582.7
(22) Date of filing: 12.11.2019
(51) Int. Cl.: H04N 21/238, G09B 9/08, H04N 21/24, H04N 21/258, H04N 21/845

(54) **AVIONICS STREAMING SERVICE**

(30) Priority: 24.01.2019 US 201916256482
(71) Applicant: Rockwell Collins, Inc., Cedar Rapids, IA 52498 (US)
(72) Inventor: MITCHELL, Andre F., Cedar Rapids, IA Iowa 52402 (US)
(74) Representative: Dehns

(57) **Abstract**

A system for streaming avionics simulator content to remote clients allows the clients to use with low-cost or commercial-off-the-shelf (COTS) visualization hardware by performing all computations and graphics generation on the server side. Avionics simulators generate interactive graphic content dynamically simulating cabin or cockpit interior environments. Streaming servers (104) connected to the simulators (102) receive simulation requests from the client-side visualization devices specifying a desired environment for simulation and parameters relevant to the desired environment (e.g., a system configuration, an aircraft configuration, a set of external conditions). The streaming servers identify the client-side visualization equipment and verify that the client-side devices are permitted to receive, and capable of receiving, the desired content. The streaming servers (104) provide content for display by the client-side visualization devices (114) via wireless network at a predetermined bandwidth suitable for complex interactive content, and receive interactive input from the client-side visualization devices (112).

## Description

### BACKGROUND

Customers and other end users may wish to utilize their personal computing devices (e.g., desktop or laptop computers) to simulate the experiences of boarding, or even controlling, a given aircraft. For example, an end user may wish to create a digital environment corresponding to a passenger cabin or other interior space. The digital "cabin" may include seating and other interior fixtures arranged to the customer's liking or arrangeable in a variety of different configurations without having to physically create such an environment. Alternatively, the end user may wish to realistically simulate the experience of piloting, co-piloting, or otherwise controlling any of a broad variety of aircraft for entertainment or training purposes, whereby the "aircraft" simulates realistic responses to control input provided by the end user.

Generally speaking, simulation content may reside on a physical medium sent directly to the customer or end user, who is then responsible for the unpacking or loading of simulation content onto their particular machine. This process may be riddled with potential complications or delays related to, e.g., the customer's operating system and hardware capabilities, the lack of appropriate input devices, or mismatching software dependencies. Further, the simulation content may be delivered under one or more software licenses to prevent end users from copying, modifying, or otherwise appropriating intellectual property to develop their own competing training and simulation systems; however, once the content is delivered via physical medium there may be no reliable safeguards preventing them from doing so.

### SUMMARY

In one aspect, embodiments of the inventive concepts disclosed herein are directed to a system for streaming avionics simulator content to remote clients with low-cost or commercial-off-the-shelf (COTS) hardware. The system includes avionics simulators incorporating processors and graphics generators to generate interactive content dynamically simulating cabin or cockpit interior environments. As all computations and graphics generation are performed by the server-side simulators, specialized hardware is not needed on the client side. The avionics simulators are linked to streaming servers for sending out the generated content via a variety of wireless network protocols. The streaming servers include onboard processors for receiving simulation requests from the client-side visualization devices specifying a desired environment for simulation and parameters relevant to the desired environment (e.g., a system configuration, an aircraft configuration, a set of external conditions). The streaming servers identify the client-side visualization equipment and verify that the client-side devices are permitted to receive, and capable of receiving, the desired content. The streaming servers provide content for display by the client-side visualization devices via wireless network at a predetermined bandwidth suitable for complex interactive content. The streaming servers receive interactive input from the client-side visualization devices, forwarding the input to the simulators so that streaming graphic content may be adjusted in real time (e.g., to simulate shifts and motion and perspective within a cabin environment, or response to control input provided through a simulated cockpit).

### BRIEF DESCRIPTION OF THE DRAWINGS

Implementations of the inventive concepts disclosed herein may be better understood when consideration is given to the following detailed description thereof. Such description makes reference to the included drawings, which are not necessarily to scale, and in which some features may be exaggerated and some features may be omitted or may be represented schematically in the interest of clarity. Like reference numerals in the drawings may represent and refer to the same or similar element, feature, or function. In the drawings:
FIG. 1 illustrates an exemplary embodiment of a system according to the inventive concepts disclosed herein; and
FIG. 2 illustrates an exemplary embodiment of a method according to the inventive concepts disclosed herein.

### DETAILED DESCRIPTION OF EXEMPLARY EMBODIMENTS

Before explaining at least one embodiment of the inventive concepts disclosed herein in detail, it is to be understood that the inventive concepts are not limited in their application to the details of construction and the arrangement of the components or steps or methodologies set forth in the following description or illustrated in the drawings. In the following detailed description of embodiments of the instant inventive concepts, numerous specific details are set forth in order to provide a more thorough understanding of the inventive concepts. However, it will be apparent to one of ordinary skill in the art having the benefit of the instant disclosure that the inventive concepts disclosed herein may be practiced without these specific details. In other instances, well-known features may not be described in detail to avoid unnecessarily complicating the instant disclosure. The inventive concepts disclosed herein are capable of other embodiments or of being practiced or carried out in various ways. Also, it is to be understood that the phraseology and terminology employed herein is for the purpose of description and should not be regarded as limiting.

As used herein a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only, and should not be construed to limit the inventive concepts disclosed herein in any way unless expressly stated to the contrary.

Further, unless expressly stated to the contrary, "or" refers to an inclusive or and not to an exclusive or. For example, a condition A or B is satisfied by anyone of the following: A is true (or present) and B is false (or not present), A is false (or not present) and B is true (or present), and both A and B are true (or present).

In addition, use of the "a" or "an" are employed to describe elements and components of embodiments of the instant inventive concepts. This is done merely for convenience and to give a general sense of the inventive concepts, and "a" and "an" are intended to include one or at least one and the singular also includes the plural unless it is obvious that it is meant otherwise.

Finally, as used herein any reference to "one embodiment," or "some embodiments" means that a particular element, feature, structure, or characteristic described in connection with the embodiment is included in at least one embodiment of the inventive concepts disclosed herein. The appearances of the phrase "in some embodiments" in various places in the specification are not necessarily all referring to the same embodiment, and embodiments of the inventive concepts disclosed may include one or more of the features expressly described or inherently present herein, or any combination of sub-combination of two or more such features, along with any other features which may not necessarily be expressly described or inherently present in the instant disclosure.

Broadly, embodiments of the inventive concepts disclosed herein are directed to a system for streaming flight trainers, cabin solution simulators, and other types of dynamic interactive avionics content to end users. All necessary computations and graphics generation is performed by simulators on the server side and streamed to end-user devices. Consequently, end users may experience complex, dynamic, and responsive content via relatively low cost off the shelf hardware.

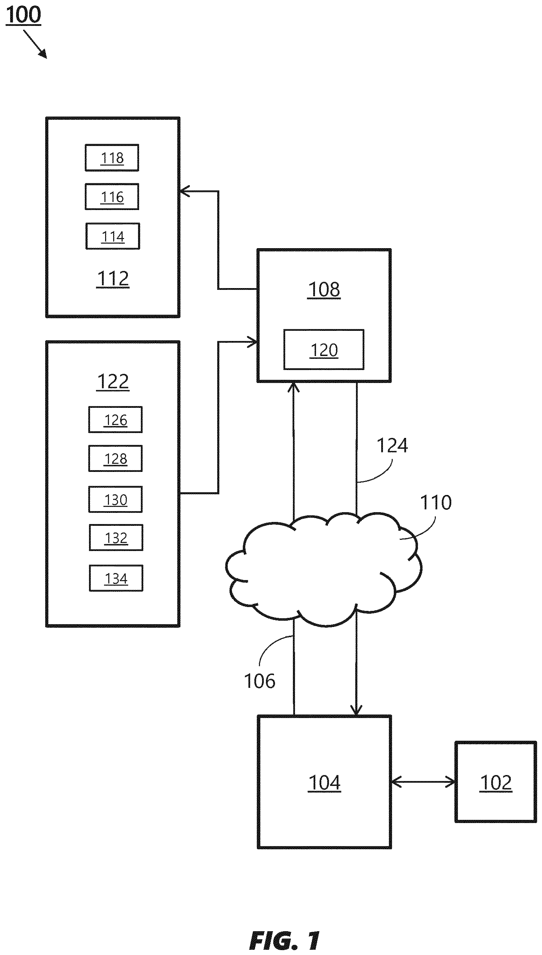

Referring to FIG. 1, an exemplary embodiment of an avionics streaming service 100 according to the inventive concepts disclosed herein may include simulators 102 and streaming servers 104. For example, the simulators 102 may include computation processors, graphics generators, renderers and other like processors capable of generating complex interactive content on the server side. The simulators 102 may generate realistic simulations of cabin or cockpit environments tailored to specific aircraft, as well as specific configurations of a particular aircraft. The generated interactive graphical content 106 may then be streamed to client devices 108 via any interconnecting network 110 providing the required bandwidth to support streaming content.

The simulators 102 may include enhanced vision (EV) and synthetic vision (SV) systems for generating dynamic symbology compatible with the generated interactive graphical content 106. For example, EV and SV systems may enable training simulations of flight operations (e.g., takeoffs, landings, approaches) in a variety of weather conditions, under instrument flight rules (IFR), or in a degraded visual environment (DVE). EV systems may simulate the experience of infrared-enhanced cockpit vision, while SV systems superimpose intuitive symbology on a graphically generated cockpit view to indicate terrain, ground features, and obstacles corresponding to a simulated position of the aircraft. The generated interactive graphical content 106 may be streamed to the client device 108 via the network 110 for display by a visualization device 112. For example, the visualization device 112 may include a touchscreen or monitor 114 incorporated into the device or a peripheral device connected thereto, e.g., a head-worn or head-mounted virtual reality (VR) visualization device 116 or augmented reality (AR) visualization device 118 (goggles, spectacles, helmet). The visualization device 112 may generate simulated three-dimensional (3D) content based on the received generated interactive graphical content 106.

As all computation and graphics rendering is executed on the server side (e.g., by the simulators 102 and streaming servers 104), a client device 108 may not require high-end hardware in order to receive and display generated interactive graphical content 106. Instead, the streaming server 104 may evaluate the capability of the client device 108 as a streaming client, e.g., via an interface application 120 executing on the client device and in communication with the streaming server. For example, the streaming server 104 may receive a simulation request from a client device 108 and verify that the account information associated with the client device has the necessary licenses or permissions to fulfill the simulation request (e.g., flying a C-130 in a DVE via an augmented reality (AR) visualization device 114). If the permissions of the client device 108 are verified, the streaming server 104 may further evaluate the processing, memory, graphics, and bandwidth capabilities of the client device and any associated visualization devices.

The end user may, via the client device 108, indicate not only the visualization devices 112 via which the generated interactive graphical content 106 may be displayed, but input or I/O devices 122 via which the end user may submit interactive input 124. For example, the end user may wish to simulate moving around a passenger cabin, viewing the cabin and its fixtures from a variety of perspectives therewithin. Similarly, an end user simulating a cockpit environment may wish to control the virtual aircraft by simulating its operations and subsystems, expecting the "aircraft" to respond in a realistic fashion corresponding to the selected aircraft's performance envelope and simulated environmental conditions (which may, along with other special features, be selected by the end user). The end user may select a touchscreen 126, keyboard 128, mouse 130 or other conventional input device for providing interactive input, a game controller 132 (e.g., joystick, paddle, gamepad, composite controller), or an AR/VR input device 134 for interacting with the simulated cockpit.

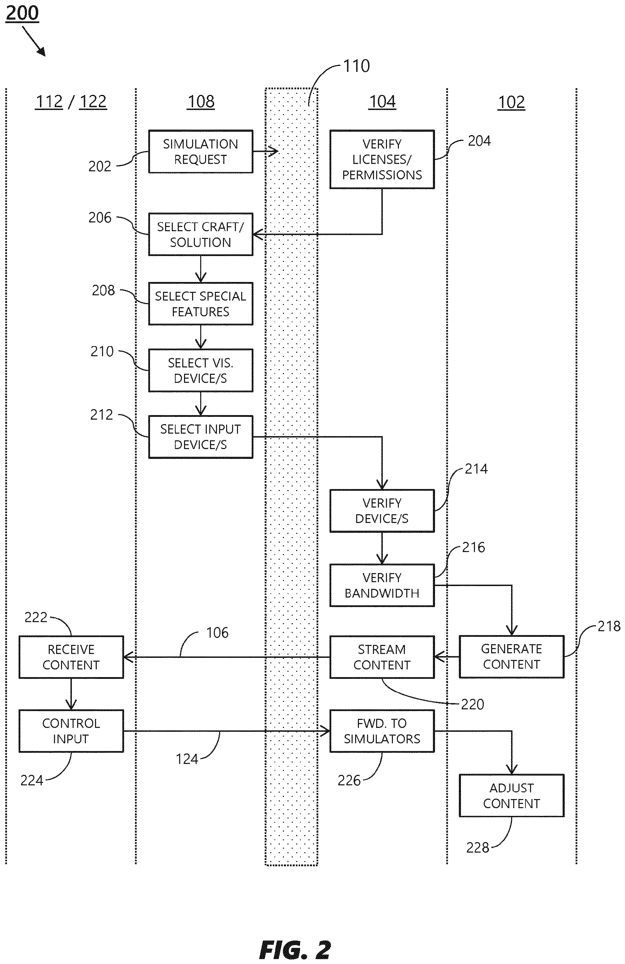

Referring now to FIG. 2, the avionics streaming service 200 may be implemented and may function similarly to the avionics streaming service 100 of FIG. 1, except that the avionics streaming service 200 may provide for the generation of interactive generated graphical avionics content 106 in response to a simulation request (202) submitted by an end user via the client device 108. For example, the end user may be interested in purchasing a state-of-the art cabin solution, e.g., a cabin solution featuring highly customized components or that may not be broadly available in physical form. The streaming servers 104 may verify (204) that the end user possesses any and all necessary and applicable licenses and permissions to stream interactive avionics content 106 (e.g., an "on demand" license) and may issue or upgrade any permissions the end user does not already possess. As all streaming avionics content 106 is generated in-house by the simulators 102 and protected by server-side firewalls and other security measures, end users may access the latest available updates without the risk of intellectual property theft.

When end user licensing and permissions are resolved, the end user may continue the simulation request by selecting a particular aircraft and/or solution (206) as well as any special features (208) associated with the selected aircraft and solution. For example, the end user may, as noted above, choose to interact with an interior cabin solution (e.g., whereby interior seating, entertainment, and other amenities are configured in a desired fashion) as though he or she is physically present within such a cabin. Alternatively, the end user may select a cockpit simulator enabling him or her to simulate flight operations via interactive controls and a simulated "aircraft" configured by the simulators 102 to respond realistically to control input, depending on selected internal or external parameters. For example, the end user may wish to undergo flight training by "controlling" a particular model of business jet under adverse weather conditions, which may include a degraded visual environment (DVE).

When the end user has specified the desired avionics content requested, the end user may complete the simulation request by specifying how the generated interactive graphical content 106 is to be experienced. For example, the end user may select (210) a particular visualization device 112 (e.g., a head-worn VR device (116, FIG. 1)) for viewing the generated content. Similarly, the end user may select (212) a particular input device 122 (e.g., a VR input device 132) via which the end user may interact with the generated interactive graphical content 106. Again, as all computation and graphics rendering is performed by the simulators 102 on the server side, the end user may ideally access and interact with highly complex generated interactive graphical content 106 via commercial off the shelf (COTS) visualization and input hardware.

When the simulation request is complete, the streaming servers 104 may verify (214) the presence of any selected input devices 122 and visualization devices 112. Similarly, the streaming servers 104 may verify (216) sufficient bandwidth between the client device 108 and the streaming servers 104 (e.g., via the network 110) so that the desired interactive graphical content 106 may be properly experienced (e.g., without lag or delay). For example, the streaming servers 104 and the client device 108 may agree on a required or minimum bandwidth for streaming generated interactive graphical content 106; should the available bandwidth drop below this level, the streaming servers 104 may buffer the generated interactive graphical content to a lower resolution.

When the desired interactive graphical content 106 and the client-side visualization devices 112 and input devices 122 have been determined, the simulators 102 may generate (218) interactive content 106 according to the simulation request 202, which the streaming servers 104 may transmit (220) across the network 110 for reception (222) by the visualization devices 112. Based on the received interactive content 106, the end user may provide (224) control input 124 via the selected input devices 122. For example, the end user may "move" within, and relative to, a simulated cabin, whereby the end user's perspective relative to fixtures, furnishings, etc. within said cabin may change. If the end user is experiencing a cockpit simulation, he or she may input steering commands, or commands to modify particular features of the simulated aircraft (e.g., control surfaces, throttle, aircraft attitude). The control input 124 may be received by the streaming servers 104 (e.g., via the network 110) and forwarded (226) thereby to the simulators 102, which adjust (228) the generated interactive graphical content 106 based on the received control input (e.g., interior and exterior views may be adjust to reflect a change in location or aircraft performance).

As will be appreciated from the above, systems and methods according to embodiments of the inventive concepts disclosed herein may allow end users to stream dynamic, highly complex interactive avionics content via relatively low-cost visualization and processing hardware. Similarly, providers may protect their content from theft and unauthorized use by generating interactive content with the protection of their own security measures.

It is to be understood that embodiments of the methods according to the inventive concepts disclosed herein may include one or more of the steps described herein. Further, such steps may be carried out in any desired order and two or more of the steps may be carried out simultaneously with one another. Two or more of the steps disclosed herein may be combined in a single step, and in some embodiments, one or more of the steps may be carried out as two or more sub-steps. Further, other steps or sub-steps may be carried in addition to, or as substitutes to one or more of the steps disclosed herein.

From the above description, it is clear that the inventive concepts disclosed herein are well adapted to carry out the objects and to attain the advantages mentioned herein as well as those inherent in the inventive concepts disclosed herein. While presently preferred embodiments of the inventive concepts disclosed herein have been described for purposes of this disclosure, it will be understood that numerous changes may be made which will readily suggest themselves to those skilled in the art and which are accomplished within the broad scope and coverage of the inventive concepts disclosed and claimed herein.

## Claims

1. A system for streaming simulator content, comprising:
one or more simulators (102), each simulator (102) including one or more first processors configured to generate interactive content associated with an aircraft environment;
at least one streaming server (104) communicatively coupled to the one or more simulators (102) and to at least one wireless network, the streaming server including one or more second processors and configured to:
receive at least one simulation request from a client visualization device via the wireless network, the simulation request corresponding to at least one of the aircraft environment and an aircraft system configuration;
identify the client visualization device based on the received simulation request;
provide for display by the client visualization device (112), via the wireless network, the interactive content corresponding to the simulation request;
receive, via the wireless network, interactive input from the client visualization device;
and
forward (226) the received interactive input to the one or more simulators (102).

2. The system for streaming simulator content of claim 1, wherein the streaming server is configured to:
determine a minimum data rate corresponding to the simulation request based on at least one of the client visualization device and the wireless network;
and
monitor a streaming data rate at which the interactive content is provided to the client visualization device.

3. The system for streaming simulator content of claim 0, wherein the streaming server (104) is configured to adjust the provided interactive content when the streaming data rate deceeds the minimum data rate.

4. The system for streaming simulator content of any preceding claim, wherein the client visualization device (112) includes at least one of an augmented reality (AR) viewer and a virtual reality (VR) viewer.

5. The system for streaming simulator content of any of claims 1 to 3, wherein the client visualization device (112) includes at least one of a head-worn display (HWD) and a head-mounted display (HMD).

6. The system for streaming simulator content of any preceding claim, wherein the one or more simulators (102) include at least one of a graphics generator, a synthetic vision system (SVS), and an enhanced vision system (EVS).

7. The system for streaming simulator content of any preceding claim, wherein the interactive input is received from at least one peripheral input device coupled to the client visualization device (112).

8. The system for streaming simulator content of claim 0, wherein the peripheral input device includes at least one of a VR input device and an AR input device.

9. The system for streaming simulator content of any preceding claim, wherein the client visualization device is configured to generate three-dimensional (3D) imagery based on the provided interactive content.

10. The system for streaming simulator content of any preceding claim, wherein the aircraft environment includes a passenger cabin.

11. The system for streaming simulator content of any preceding claim, wherein:
the aircraft environment includes an aircraft cockpit;
and
the aircraft system configuration is associated with at least one simulated aircraft control.
